# EUROPÄISCHE PATENTSCHRIFT

(11) **EP 0 640 474 B1**
(45) Veröffentlichungstag und Bekanntmachung des Hinweises auf die Patenterteilung: **27.06.2001**
(21) Anmeldenummer: 94112885.2
(22) Anmeldetag: 18.08.1994
(51) Int. Cl.: B32B 31/12, B32B 27/16, B29C 59/12, B29C 59/14, C23C 14/10, C23C 14/20, C23C 14/24, B29K 105/32

(54) **Verbundfolien**
Laminated films
Feuilles laminées

(30) Priorität: 26.08.1993 DE 4328767
(43) Veröffentlichungstag der Anmeldung: 01.03.1995
(73) Patentinhaber: FRAUNHOFER-GESELLSCHAFT ZUR FÖRDERUNG DER ANGEWANDTEN FORSCHUNG E.V., 80636 München (DE)
(72) Erfinder: Utz, Helmar, Dipl.-Chem., D-85356 Freising (DE)

(56) Entgegenhaltungen:
- EP-A- 0 026 106
- EP-A- 0 064 219
- EP-A- 0 460 796
- EP-A- 0 475 441
- EP-A- 0 545 863
- EP-A- 0 550 039
- DE-A- 3 300 411
- FR-A- 1 421 884
- US-A- 3 959 567
- US-A- 4 511 419
- PATENT ABSTRACTS OF JAPAN vol. 15, no. 82 (E-1038) 26. Februar 1991 & JP-A-02 299 106 (NITTO DENKO CORP) 11. Dezember 1990
- PATENT ABSTRACTS OF JAPAN vol. 3, no. 152 (C-067) 14. Dezember 1979 & JP-A-54 127 990 (TEIJIN LTD) 4. Oktober 1979
- DATABASE WPI Week 8930, Derwent Publications Ltd., London, GB; AN 89-215699 & JP-A-1 152 054 (TORAY IND INC) 14. Juni 1989
- Dissertation Helmar Utz vom 24.04/16.08.1995, Fakultät für Brauwesen, Lebensmitteltechnologie und Milchwissenschaft der Technischen Universität München, mit dem Titel: "Barriereeigenschaften aluminiumbedampfter Kunststoffolien"

## Beschreibung

Die Erfindung betrifft ein Verfahren zum Aufbringen von transparenten nichtmetallischen Schichten die Barriere- und Verbindungseigenschaften besitzen mit ausgewählten Ausgangsverbindungen zwischen zwei Folien an sich bekannter Art im Vakuum.

Folienverbunde, die aus zwei Folien und Verbindungsschichten mit bestimmten Funktionen bestehen, sind bekannt. Es gibt hier Folienverbunde, die eine Funktionszwischenschicht aufweisen, welche lichtdurchlässig ist und die gleichzeitig als Barriere (die Gasdurchlässigkeit vermindernde Sperrschicht) wirkt. Weitere Funktionszwischenschichten sind bekannt, die lichtdurchlässig aber gleichzeitig elektrisch leitende Schichten aufweisen.

Funktionszwischenschichten sind ebenfalls hergestellt worden, die aus im sichtbaren Bereich transparente aber infrarote Strahlung reflektierende Schichten darstellen.

Zum Herstellen von derartigen Folienverbunden werden derzeit unterschiedlichste Verfahren eingesetzt.

Neben der Coextrusion, der (Co-)Extrusionsbeschichtung und Extrusionslaminierung ist die Kaschierung von Folien, bei welcher zwei Folienbahnen mit Hilfe eines Klebstoffes verbunden werden, das am häufigsten angewandte Verfahren.

Folien mit vakuumtechnisch aufgebrachten Funktionsschichten (z.B. Aluminium oder SiOₓ als Sperrschicht gegenüber Gasen oder Aromastoffen) werden fast ausschließlich durch Kaschierung zu Verbunden verarbeitet. Durch das Aufbringen einer zweiten Folie wird eine gute Siegelfähigkeit des Verbundes erzielt und gleichzeitig die sehr empfindlichen aufgedampften Schichten vor mechanischer Beanspruchung oder auch dem Einfluß der Umgebung geschützt, da die Dünnschicht zwischen den beiden dickeren Folien eingebettet ist.

Mit sogenannten "bedampften" Folien muß sowohl bei der Herstellung als auch bei der Weiterverarbeitung äußerst vorsichtig umgegangen werden, da bereits geringe mechanische Beanspruchungen zu einer deutlichen Verschlechterung der Barriereeigenschaften führen.

Aus Umweltgründen versucht man heute, Produkte möglichst so zu gestalten, daß sie nach ihrem Gebrauch recyclet werden können. Dies gilt insbesondere für Verpackungsmaterialien. Verbunde stellen unter diesem Gesichtspunkt wegen der Materialvielfalt ein großes Problem dar. Man versucht daher, möglichst einheitliche und daher besser gemeinsam recyclebare Ausgangsstoffe zu verwenden. So gibt es z.B. bereits reine Polyolefinverbunde mit einer SiOₓ-Sperrschicht. Um einen derartigen Verbund herzustellen, ist es derzeit allerdings notwendig, Kaschierkleber zu verwenden, die nach dem Aushärten ein nicht schmelzbares Netzwerk ausbilden, welches sich beim Recycling störend auswirkt.

Zur Erzielung einer besseren Umweltverträglichkeit wird auch versucht, biologisch abbaubare bzw. kompostierbare Verpackungen zu entwickeln. Hauptnachteile der heute zur Verfügung stehenden biologisch abbaubaren Kunststoffe sind deren schlechte Sperreigenschaften, insbesondere gegenüber Wasserdampf. Man versucht daher durch den Einsatz der vakuumtechnischen Beschichtung die Sperreigenschaften zu verbessern. Wie "bedampfte" konventionelle Folien sind auch "bedampfte" biologisch abbaubare Folien äußerst empfindlich gegenüber mechanischen Beanspruchungen bei der Herstellung und der Weiterverarbeitung, welche zu Barriereverschlechterung führen. Die aufgedampften Schichten müssen daher zu ihrem Schutz eingebettet (zweite Folie, Lackierung... ) werden. Zur Erzielung einer guten Siegelfähigkeit ist es notwendig, eine Siegelschicht auf die bedampfte biologisch abbaubare Folie aufzutragen. Wie bei konventionellen Verbunden kann dies durch Kaschierung erfolgen. Hierfür einzusetzende Kaschierkleber sind allerdings nicht biologisch abbaubar bzw. kompostierbar wie die bedampften Folien und die Siegelschicht. Sie können daher bei der Kompostierung stören.

Zur Energieeinsparung werden häufig beschichtete Architekturgläser eingesetzt. Durch Auftragen von dünnen Schichten im Vakuum können Gläser mit hoher Wärmedämmwirkung und/oder Sonnenschutzwirkung erzielt werden. Für denselben Zweck beschichtet man auch Folien, die auf Fensterscheiben aufgebracht werden könne. Derartige Folien sind einseitig beschichtet, d.h. die Funktionsschicht liegt vor der Kaschierung z.B. auf Glas frei, sie können daher leicht mechanisch oder bei entsprechender Empfindlichkeit gegenüber Umwelteinflüssen (z.B. Silberschicht gegenüber Cl- und S-Verbindungen) beschädigt werden.

Für elektrooptische Bauelemente, wie z.B. Flüssigkristallanzeigen, werden elektrisch leitfähige, für sichtbares Licht transparente Beschichtungen z.B. auf Glas oder Kunststoffen eingesetzt. Auch hier liegt die aufgebrachte Schicht offen und kann bei der Weiterverarbeitung leicht beschädigt werden.

Aus der GB 2 064 427A (= EP 0 026 106 A1) ist ein Folienverbund bekannt, der zwar ohne Kaschierkleber hergestellt wird, die dabei vorgeschlagene Schicht wird aber mittels eines oxidierbaren Metalls aufgedampft, welches durch seine Getterwirkung gegenüber Sauerstoff eine Oxidation der Metalloberflächen vor der Verbindungsbildung verhindert, was aber bewirkt, daß Folienverbunde entstehen, die in ihrer Transparenz eingeschränkt sind.

Alle Folienverbunde mit transparenten Funktionszwischenschichten haben somit den Nachteil, daß sie unter Verwendung eines Kaschierklebers hergestellt werden und somit schlecht oder sogar gar nicht recyclet werden können, wobei als zusätzlicher Nachteil noch verminderte Barriereeigenschaften in Kauf genommen werden müssen.

Die Folienverbunde, die nach der GB 2 064 427 (= EP 0 026 106 A1) hergestellt werden, weisen zwar eine Funktionszwischenschicht auf, die ohne Kaschierkleber eingebracht ist, diese Funktionszwischenschicht hat aber den entscheidenden Nachteil, daß sie metallisch und nicht transparent genug ist und somit nicht für die vorstehend beschriebenen Anwendungen eingesetzt werden kann.

Aus der EP 0 064 219 A1 ist ein Verfahren und eine Vorrichtung zum Kaschieren von Werkstoffbahnen bekannt. Darin wird zum festen und dauerhaften Kaschieren von Werkstoffbahnen eine Oberflächenbehandlung im Vakuum vorgeschlagen, wobei Ethylengas in den Entladungsraum eingeleitet wird. In der US 4,511,419 wird eine Methode und eine Vorrichtung zum Laminieren von Folien beschrieben. Auch in diesem US-Patent ist ein Verfahren beschrieben, bei dem eine Oberflächenbehandlung im Vakuum mittels eines Plasmagases durchgeführt wird.

Aus der EP 0 460 796 A3 ist es bekannt, dotierte SiO₂-Schichten und gegebenenfalls glasartige Schichten mit Sperreigenschaften auf Folien abzuscheiden. Die EP 0 550 039 A3 offenbart die Abscheidung von Gläser zur Erzielung von Sperreigenschaften, wobei die Sperrschicht dadurch geschützt werden kann, daß ein organischer Polymerfilm gegebenenfalls unter Zuhilfenahme eines Adhäsivs auflaminiert wird.

Die EP 0 545 863 A1 betrifft das Beschichten einer Substratfläche mit einer Permeationssperre. Die Permeationssperre ist dabei ein anorganisches Material. Letztlich betrifft die DE 33 00 411 A1 ein transparentes Laminat. Dieses transparente Laminat besteht aus einem transparenten Kunstharzfilm- oder Foliensubstrat, einer dünnen Schicht aus mindestens einem Metall und einer auf der Metallschicht durch Auflaminieren aufgebrachten Polyolefinschicht.

Ausgehend hiervon ist es die Aufgabe der vorliegenden Erfindung, ein verfahren zur Verfügung zu stellen, mit dem Verbundfolien hergestellt werden können, die ohne Kaschierkleber aufgebaut sind, wobei gleichzeitig gefordert ist, daß keine Einschränkungen hinsichtich der Funktion der Schicht entstehen.

Die Aufgabe wird durch die kennzeichnenden Merkmale des Anspruchs 1 gelöst. Die Unteransprüche 2 bis 6 zeigen vorteilhafte Weiterbildungen auf.

Mit der vorliegenden Erfindung ist es erstmalig möglich, Klebstoffreie und daher voll recyclebare Folienverbunde, mit gegenüber den Ausgangsmaterialien wesentlich verbesserten Sperreigenschaften herzustellen. Die transparente nichtmetallische Sperrschicht wirkt dabei gleichzeitig als Verbindungsschicht. Damit ist das Problem gelöst, daß das Recycling von Polymerverbunden durch den in den Polymerverbunden enthaltenen Kaschierkleber nur sehr schwer oder gar nicht möglich ist.

Wenn nun biologisch abbaubare Folien ausgewählt werden, kann ein vollständig biologisch abbaubarer Polymerverbund hergestellt werden. Eine Kompostierung ist damit problemlos möglich.

Erfindungsgemäß wird die transparente Schicht dadurch hergestellt, daß bereits bei der Herstellung des Verbundes die Schicht in einem einstufigen Prozeß, durch ein geeignetes Verfahren, zwischen zwei Folien eingebracht wird. Erfindungsgemaß wird im Vakuum durch Verdampfen eine nichtmetallische transparente Barriere- und Verbindungsschicht mit dem in Anspruch 1 angegebene Verbindungen aufgebracht. Ürraschenderweise hat sich gezeigt, daß es mit nichtmetallischen Funktionszwischenschichten möglich ist, Verbunde herzustellen, die eine Zwischenschicht aufweisen, die gleichzeitig als Verbindungsschicht und Sperrschicht wirkt. Die Schichtdicke liegt im Bereich von 10 bis 1000 nm.

Nach der GB 2 064 427 ist es dabei wichtig, daß für eine gute Verbindungsbildung vorhandener Sauerstoff durch das aufzudampfende Metall gegettert wird und somit nicht zur Oxidation der Verbindungsschicht führt. Es war demnach zu erwarten, daß oxidische Verbindungen für eine derartige Funktionszwischenschicht mit gleichzeitiger Verbindungswirkung nicht geeignet sind.

Im Gegensatz dazu hat sich gezeigt, daß der vorhandene Sauerstoff bei den erfindungsgemäßen Verbunden nicht stört. Beim Aufdampfen z. B. von Oxiden hat das Vorhandensein von Sauerstoff sogar noch den Vorteil, daß dabei auftretender Sauerstoffverlust, welcher zur Suboxidbildung fÜhrt, sogar ausgeglichen wird. Überraschenderweise hat sich gezeigt, daß mit dem erfindungsgemäßen Verfahren transparente Barriereschichten entstehen, die gleichzeitig als Verbindungsschicht wirken.

Erfindungsgemaß sind die Verbindungen ausgewählt aus: Aluminiumoxid, Ceroxid, Hafniumoxid, Magnesiumoxid, Siliciumdioxid, Siliciummonoxid, Tantaloxid, Titandioxid, Titan(3)oxid, Titanmonoxid, Yttriumoxid, Zirkonoxid, Zirkonmonoxid Indium-/Zinnoxid,

Bleifluorid, Calciumfluorid, Cerfluorid, Kryolith, Lanthanfluorid, Magnesiumfluorid, Neodymfluorid, Thoriumfluorid,

Cadmiumsulfid, Zinksulfid, Bleitellurid, Cadmiumtellurid, Zinktellurid, Cadmiumselenid Zinkselenid, Gläser oder Mischungen davon.

Mit dem erfindungsgemäßen Verfahren können somit Polymerverbunde mit einer, zwei, drei oder mehr Schichten hergestellt werden. Die Anzahl der Schichten richtet sich je nach Anforderungen, die an den Polymerverbund gestellt werden. Je nachdem können demnach eine oder zwei bzw. drei Schichten, wobei die Ausgangsmaterialien entsprechend ausgewählt werden, aufgebracht werden.

Eine bevorzugte Ausführungsform schlägt nun noch vor, daß zusätzlich zu den nichtmetallischen Schichten eine genügend dünne und daher transparente metallische Schicht aufgebracht wird. Diese metallische Schicht dient dann z.B. bei Silber zur Erzeugung einer Wärmedämmung ohne Sonnenschutzwirkung. Als Metalle eignen sich dabei alle aus dem Stand der Technik bekannten Metalle zur Erzeugung von dünnen Schichten, wie z.B. Aluminium, Antimon, Blei, Cadmium, Eisen, Gallium, Germanium.

Die Schichten können dabei zwischen die Folien mit allen aus dem Stand der Technik bekannten Verfahren durch Verdampfen aufgebracht werden. Grundsätzlich eignen sich dafür ein thermisches Verdampfen, Kathodenzerstäubung sowie CVD.

Die Polymerverbunde können dabei aus zwei identischen Folien oder zwei verschiedenen Folien und jeweils mindestens eine Barriere- und Verbindungsschicht aufgebaut sein. Als Folien kommen hierbei alle aus dem Stand der Technik bekannten Folien in Frage, wie z.B. Polyester, Polypropylen, Polyethylen, Polyamid, Polycarbonat, regenerierte Zellulose, Zelluloseacetat, Hydroxybuttersäure-Copolymere, stärkebasierte Kunststoffe oder Kunststoffe mit Stärkezusatz, aliphatische Polycarbonate und Polyester wie Polycaprolacton, Polymilchsäure, Milchsäurecopolymere, Polyethylensuccinat und Polybutylensuccinat, Polypeptide, Polysaccharide, Papier, Karton oder andere biologisch abbaubare Materialien sowie deren Kombinationen als Verbund oder Mischung bzw. in beschichteter Form.

Da die erfindungsgemäß erforderliche Barriere- und Verbindungsschicht bereits bei der Bildung immer zwischen zwei Folien eingebettet wird, ist sie sowohl bei der Herstellung als auch bei weiteren Verarbeitungsschritten gegen mechanische Einflüsse und andere Umgebungseinflüsse sehr gut geschützt und daher weniger empfindlich.

Folien mit Wärmedämm- und/oder Sonnenschutzwirkung bzw. Folien, die elektrisch leitfähig und für Licht transparent sind, können bereits bei der Herstellung kaschiert werden. Die funktionelle Schicht ist durch die Einbettung zwischen zwei Kunststoffolien sehr gut geschützt. Derartige Folien weisen wesentliche Vorteile sowohl bei der Weiterverarbeitung (z.B. geringe Gefahr mechanischer oder auch chemischer Beschädigung) als auch bei der Anwendung (z.B. direkte Verwendung ohne weiteren Träger) auf.

Weitere Einzelheiten, Merkmale und Vorteile der vorliegenden Erfindung ergeben sich aus der nachfolgenden Beschreibung der Figuren 1 bis 5 sowie der Ausführungsbeispiele 1 bis 5.

Figur 1 zeigt den schematischen Aufbau einer beispielhaften Hochvakuum-Bandbedampfungsanlage mit einem Verdampfer.

Figur 2 zeigt den beispielhaften Aufbau einer Hochvakuum-Bandbedampfungsanlage mit mehreren Verdampfern.

Figur 3 zeigt den beispielhaften Aufbau einer Bandbedampfungsanlage zur Erzeugung von z.B. Wärmedämm-bzw. Sonnenschutzverbundfolien.

Figur 4 zeigt die Ausführungsform mit einer Bedampfungswalze.

Figur 5 zeigt verschiedene erfindungsgemäße Verbundfolien.

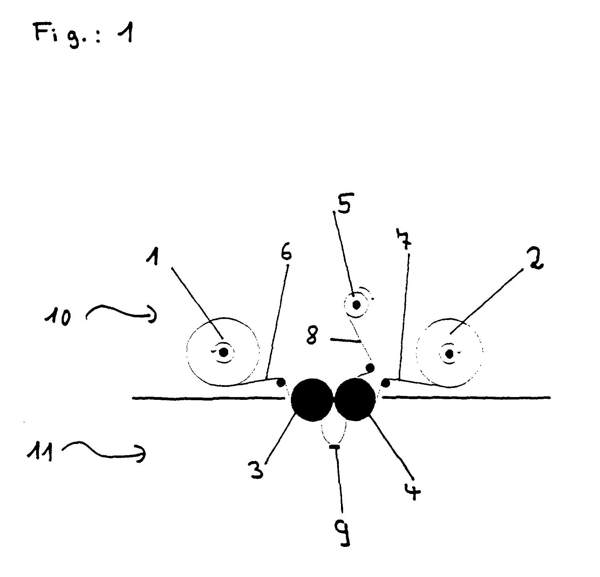

In der Ausführungsform nach Figur 1 besteht die Hochvakuum-Bandbedampfungsanlage aus einer Wickelkammer 10 und einer Bedampfungskammer 11. In der Bedampfungskammer 11 werden zwei bahnförmige Folien 6, 7 aus der Wickelkammer 10 über zwei Bedampfungswalzen 3, 4 in der Bedampfungskammer 11 zusammengeführt. Aus einem Verdampfer 9 wird das Verdampfungsgut (z.B. oxidische Verbindung) in den Spalt zwischen die beiden Walzen 3 und 4 verdampft. Das auf den Folien 6, 7 kondensierende Verdampfungsgut verbindet die Folie 6, 7 und bildet gleichzeitig eine Sperrschicht. Der sich bildende Polymerverbund 8 wird auf einer Walze 5 aufgewickelt.

Das erfindungsgemäße Verfahren kann dabei, wie in Figur 1 abgebildet, mit einer Zwei-Kammer-Anlage mit den Folien 6,7 innerhalb der Kammer 10,11, oder aber in einer Ein-Kammer-Anlage oder auch in sog. "Air-to-air-Anlagen" bei welchem die Folien durch Schleusen in die eigentliche Bedampfungskammer eingeführt werden, durchgeführt werden.

Als Verdampfungsquellen können neben üblichen thermischen Verdampfern, wie z.B. Schiffchen oder größere Tiegel, die direkt widerstandsbeheizt, induktiv oder indirekt durch Strahlung beheizt werden, aber auch Elektronenstrahlverdampfer oder Magnetrons eingesetzt werden. Zusätzlich kann zur Aktivierung ein Plasma in der Bedampfungszone eingekoppelt werden.

Die eingesetzten Folien können zudem vor der Bedampfung z.B. durch ein Plasma oder Glimmentladung in der Anlage vorbehandelt werden.

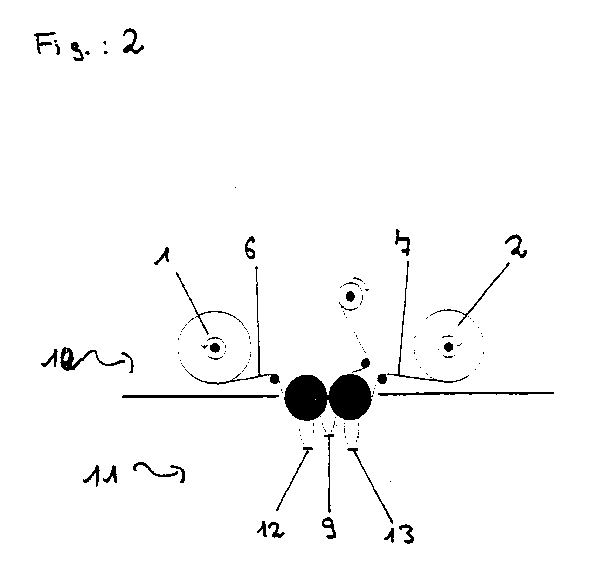

Figur 2 zeigt nun eine Ausführungsform entsprechend Figur 1, nur mit mehreren Verdampfungsquellen. Mit dieser Verfahrensweise kann durch die zusätzlichen Verdampfer 12 und 13 bereits vor der eigentlichen Verbindungsbildung andere Substanzen auf die Folien aufgedampft werden. Grundsätzlich können, wie in Figur 2 abgebildet, drei Verdampfer oder aber auch nur zwei Verdampfer verwendet werden. Die Mittelschicht, die mit dem Verdampfer 9 aufgebracht wird, kann z.B. aus einem Metall bestehen, welches eine Verbindungsbildung fördert und so dünn ist, daß es noch transparent ist.

Durch die Verdampfer 12 und 13 können nun die Verbindungen nach Anspruch 1 aufgebracht werden. Dadurch werden nun vor der eigentlichen Verbindungsbildung andere Substanzen auf die Folien aufgebracht.

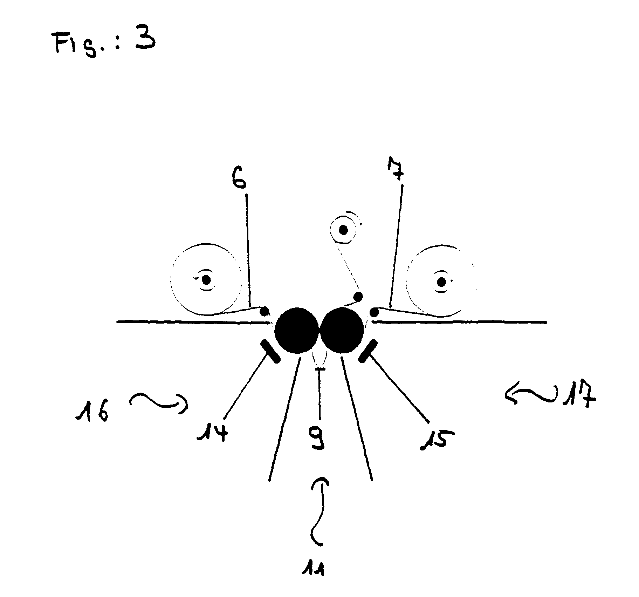

Figur 3 zeigt nun eine Ausführungsform, bei der die Verdampfer 12 und 13 durch Sputterquellen 14, 15, die in einen Sputterkammer 16, 17 angeordnet sind, ersetzt sind. Auch bei dieser Ausgestaltung des erfindungsgemäßen Verfahrens werden nun die einzelnen Folien 6, 7, bevor sie der Verbindungsbildung unterzogen werden, mit separaten Schichten beschichtet.

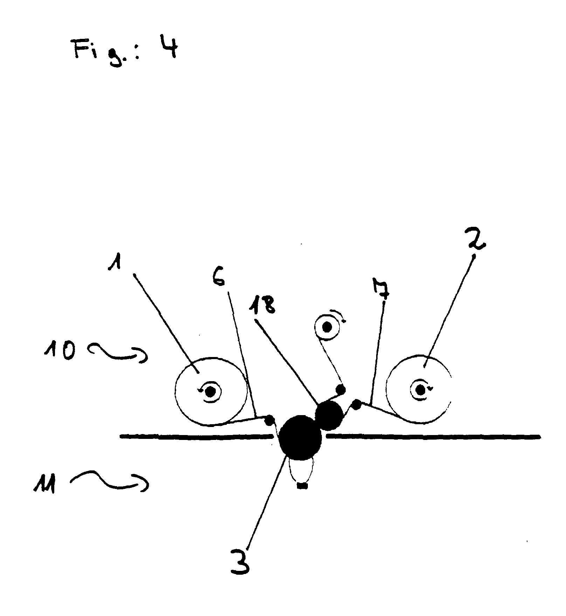

Figur 4 zeigt nun ein Ausführungsbeispiel des erfindungsgemäßen Verfahrens bei dem die Funktionszwischenschicht zuerst auf ein über eine Bedampfungswalze 3 geführte Folie 6 aufgebracht wird.

Überraschenderweise hat sich gezeigt, daß zur Verbindungsbildung zwischen zwei Folien durch Aufdampfen nicht zwingend beide Folien im Spalt zwischen den beiden Bedampfungswalzen 3,4 (bei der Zusammenführung) bedampft werden müssen. Vielmehr kann es ausreichend sein, daß nur eine Folie bedampft wird. Eine einzige Bedampfungswalze 3 ist dabei ausreichend. Die zweite Folie 7 wird nach Bedampfung der ersten Folie 6 zugeführt und z.B. durch eine Anpreßwalze 18 auf der Bedampfungswalze 3 auf die bedampfte Seite der Folien aufgedrückt.

Um eine Verbindung der beiden Folien 6, 7 zu erhalten, muß die aufgedampfte Schicht reaktiv gegenüber der zugeführten Folienoberfläche sein und ein hoher Druck ausgeübt werden, um einen engen Kontakt der Oberflächen zu bewirken. Wird z.B. Siliciummonoxid aufgedampft, so nimmt die aufgedampfte SiOₓ-Schicht noch Sauerstoff auf. Wird eine glatte Folienoberfläche mit entsprechenden reaktiven Gruppen (z.B. coronavorbehandeltes Polypropylen) mit der noch reaktiven SiOₓ-Schicht in engen Kontakt gebracht, so kommt es zu Verbindungsbildung.

Bei den zugeführten Folien können alle Folien verwendet werden, deren Oberflächen mit der reaktiven Oberfläche der aufgedampften Schicht eine Verbindung bilden können (z.B. Sauerstoff liefern). Die Folienoberfläche sollte möglichst glatt sein, um einen engen Kontakt zu ermöglichen. Die Folie kann hierzu coextrudiert oder auch lackiert bzw. beschichtet sein. Eine Aktivierung der Folienoberfläche kann z.B. auch durch eine Vorbehandlung (Corona, Beflammung, Plasma, Glimmentladung oder Behandlung mit z.B. Ozongas), in oder außerhalb der Bedampfungsanlage erfolgen.

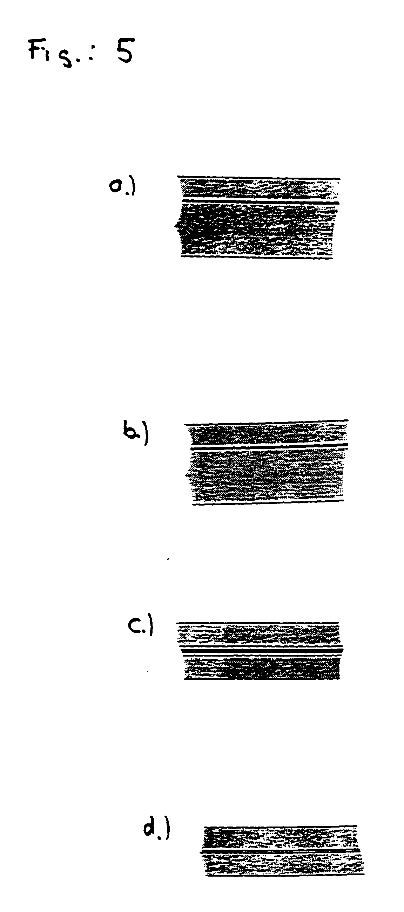

Figur 5 zeigt mit den erfindungsgemäßen Verfahren hergestellte Verbundfolien.

Figur 5a zeigt einen Sperrschichtverbund ohne Kaschierkleber unter Verwendung von orientiertem Polypropylen mit einer Schichtdicke von 20 *µ*m, einer SiOₓ-Sperrschicht und siegelfähigem Polypropylen mit einer Schichtdicke von 50 *µ*m.

Figur 5b zeigt einen biologisch abbaubaren Sperrschichtverbund ohne Kaschierkleber, mit PHB als Substrat (16 *µ*m) einer SiOₓ-Sperr- bzw. Verbindungsschicht und thermoplastischer Stärke in einer Schichtdicke von 50 *µ*m als zweite Folie.

Figur 5c zeigt eine Wärmedämmschicht geschützt zwischen zwei Polyesterfolien, die gleichzeitig als Träger dienen. Dieser Verbund ist so aufgebaut, daß die mittlere Schicht eine Silberschicht ist, die von Indiumoxid-/Zinnoxid-Schichten umgeben ist. Als Folie fungiert in diesem Fall eine PET-Schutz- bzw. Trägerfolie.

Figur 5d zeigt eine optisch transparente, elektrisch leitfähige Oxidschicht, die durch zwei Polyesterfolien geschützt ist. Als Schicht wirkt hier eine Indium-/Zinnoxidschicht, die durch PET-Schutz- bzw. Trägerfolien geschützt ist.

### Beispiel 1

Gemäß Figur 1 werden eine 20 *µ*m dicke biaxial-orientierte Polypropylenfolie und eine 70 *µ*m dicke cast-Polypropylenfolie (siegelfähig) mit 100 nm SiO bedampft. Hierdurch erhält man einen recyclefähigen Polypropylenverbund, wie in Figur 5a dargestellt, bei welchem die Sperrschicht bereits bei der Erzeugung eingebettet vorliegt und daher vor Beschädigung geschÜtzt ist. Der Verbund kann z.B. als Verpackungsmaterial eingesetzt werden.

### Beispiel 2

Gemäß Figur 1 werden eine 16 *µ*m dicke biaxial-orientierte Folie aus Hydroxybuttersäure-Hydroxyvaleriansäure-Copolymer und eine 50 *µ*m dicke Folie aus thermoplastischer Stärke mit 100 nm SiO bedampft. Der hierdurch erzeugte Verbund (Figur 5b) ist biologisch abbaubar bzw. kompostierbar und kann z.B. für kurzlebige Verpackungen eingesetzt werden. Die Sperrschicht wird bereits bei der Erzeugung geschützt und ist daher weniger empfindlich.

### Beispiel 3

Gemäß Figur 3 werden zwei Polyesterfolien in den Sputterkammern 14 und 17 jeweils mit einer Mischung aus Indium- und Zinnoxid beschichtet. In der Bedampfungskammer 11 werden die beschichteten Folien zusammengeführt, wobei in den Spalt zwischen den beiden Bedampfungswalzen 3, 4 Silber verdampft wird. Das so erzeugte "Sandwich" kann z.B. als Wärmedämmfolie freitragend oder auf Glas aufgebracht werden. Durch die Einbettung der eigentlichen funktionellen Schicht zwischen zwei Polyesterfolien ist diese vorteilhaft geschützt (Figur 5c).

### Beispiel 4

Gemäß Figur 1, wobei der Verdampfer durch eine Kathodenzerstäubungseinrichtung ersetzt ist, wird in einen Spalt zwischen zwei Polyesterfolien Indiumoxid mit Beimengungen von Zinnoxid aufgesputtert. Es entsteht hierdurch eine elektrisch leitfähige, für sichtbares Licht transparente Schicht, die geschützt zwischen zwei Polyesterfolien eingebettet, vorliegt (Figur 5d). Das so erzeugte Material kann z.B. für elektrooptische Bauelemente eingesetzt werden.

### Beispiel 5

Eine 20 *µ*m dicke OPP-Folie wird analog Figur 4 auf einer leicht modifizierten konventionellen Bandbedampfungsanlage mit 100 nm SiOₓ bedampft. Dabei wird auf der Bedampfungswalze (nach der Bedampfung) eine 70 *µ*m dicke siegelfähige coextrudierte cast-PP-Folie zugeführt und mit einer Anpresswalze stark auf die bedampfte Seite des Substrates angedrückt. Die coextrudierte cast-PP-Folie besteht aus einer zusatzstofffreien Schicht und einer konventionellen Schicht mit Antiblockmittel. Die zusatzstofffreie Schicht wurde coronavorbehandelt. Diese Seite der Folie kommt auf die Siliciumoxidschicht. Die dabei in der Bedampfungsanlage gebildete doppellagige Folie wird gemeinsam auf eine Rolle aufgewickelt. Zur Verbindungsbildung wird diese Rolle sofort nach der Fertigstellung in einer Druckkammer unter hohem Druck eingelagert. Nach dem Abreagieren der aufgedampften Siliciumoxidschicht entsteht ein fester, recyclefähiger Verbund- mit einer SiOₓ-Sperrschicht als Verbindungsschicht.

## Patentansprüche

1. Verfahren zum Herstellen von Folienverbunden ohne Kaschierkleber, bei dem bei der Herstellung des Verbundes zwischen zwei Folien im Vakuum durch Verdampfen mindestens eine nichtmetallische transparente Barriere- und Verbindungsschicht mit einer Dicke von 10 bis 1000 nm aufgebracht wird, die ausgewählt ist aus der Gruppe der folgenden Verbindungen
Aluminiumoxid, Ceroxid, Hafniumoxid, Magnesiumoxid, Siliciumdioxid, Siliciummonoxid, Tantaloxid, Titandioxid, Titan(3)oxid, Titanmonoxid, Yttriumoxid, Zirkonoxid, Zirkonmonoxid, Indium-/Zinnoxid, Bleifluorid, Calciumfluorid, Cerfluorid, Kryolith, Lanthanfluorid, Magnesiumfluorid, Neodymfluorid, Thoriumfluorid, Cadmiumsulfid, Zinksulfid, Bleitellurid, Cadmiumtellurid, Zinktellurid, Cadmiumselenid, Zinkselenid, Gläser oder Mischungen davon.

2. Verfahren nach Anspruch 1, dadurch gekennzeichnet, daß die Schicht zwischen zwei über Bedampfungswalzen gegeneinander geführte Folien aufgebracht wird.

3. Verfahren nach Anspruch 1 oder 2, dadurch gekennzeichnet, daß zusätzlich eine dünne und transparente Metallschicht aufgebracht wird.

4. Verfahren nach einem der Ansprüche 1 bis 3, dadurch gekennzeichnet, daß die Schichten durch thermisches Aufdampfen aufgebracht werden.

5. Verfahren nach einem der Ansprüche 1 bis 4, dadurch gekennzeichnet, daß die Barriere- und Verbindungsschicht durch Kathodenzerstäubung aufgebracht wird.

6. Verfahren nach einem der Ansprüche 1 bis 5, dadurch gekennzeichnet, daß die Folien ausgewählt sind aus der Gruppe Polyester, Polypropylen, Polyethylen, Polyamid, Polycarbonat, regenerierte Zellulose, Zelluloseacetat, Polyhydroxybuttersäure und deren Copolymere, stärkebasierte Kunststoffe oder Kunststoffe mit Stärkezusatz, aliphatische Polycarbonate und Polyester, Polypeptide, Polysaccharide, Papier, Karton oder andere biologisch abbaubare Materialien, sowie deren Kombinationen als Verbund oder Mischung bzw. in beschichteter Form.

## Claims

1. Method of manufacturing laminated films without laminating adhesive, in which, during the production of the composite, at least one non-metallic transparent barrier and connecting layer having a thickness of between 10 and 1000 nm is applied between two films by vapour deposition in a vacuum, which layer is selected from the group of the following compounds:
aluminium oxide, cerium oxide, hafnium oxide, magnesium oxide, silicon dioxide, silicon monoxide, tantalum oxide, titanium dioxide, titanium (3) oxide, titanium monoxide, yttrium oxide, zirconium oxide, zirconium monoxide, indium/zinc oxide, lead fluoride, calcium fluoride, cerium fluoride, cryolite, lanthanum fluoride, magnesium fluoride, neodymium fluoride, thorium fluoride, cadmium sulphide, zinc sulphide, lead telluride, cadmium telluride, zinc telluride, cadmium selenide, zinc selenide, glass or mixtures thereof.

2. Method according to claim 1, characterised in that the layer is applied between two films guided against one another over vaporisation rollers.

3. Method according to claim 1 or 2, characterised in that in addition a thin and transparent metal layer is applied.

4. Method according to one of claims 1 to 3, characterised in that the layers are applied by thermal vapour deposition.

5. Method according to one of claims 1 to 4, characterised in that the barrier and connecting layer is applied by cathodic sputtering.

6. Method according to one of claims 1 to 5, characterised in that the films are selected from the group: polyester, polypropylene, polyethylene, polyamide, polycarbonate, re-generated cellulose, cellulose acetate, polyhydroxy butanoic acid and its copolymers, starch-based plastics materials or plastics materials with a starch additive, aliphatic polycarbonates and polyesters, polypeptides, polysaccharides, paper, cardboard or other bio-degradable materials, as well as combinations of these as a composite or mixture or in laminated form.

## Revendications

1. Procédé pour la fabrication de feuilles stratifiées sans adhésif pour contrecollage, dans lequel, lors de la fabrication du stratifié, est appliquée entre deux feuilles, par vaporisation sous vide, au moins une couche transparente de barrière et d'assemblage, non métallique, ayant une épaisseur de 10 à 1 000 nm, qui est choisie dans l'ensemble constitué par les composés suivants l'oxyde d'aluminium, l'oxyde de cérium, l'oxyde d'hafnium, l'oxyde de magnésium, le dioxyde de silicium, le monoxyde de silicium, l'oxyde de tantale, le dioxyde de titane, l'oxyde de titane-(III), le monoxyde de titane, l'oxyde d'yttrium, l'oxyde de zirconium, l'oxyde d'indium, l'oxyde d'étain, le monoxyde de zirconium, le fluorure de plomb, le fluorure de calcium, le fluorure de cérium, la cryolithe, le fluorure de lanthane, le fluorure de magnésium, le fluorure de néodyme, le fluorure de thorium, le sulfure de cadmium, le sulfure de zinc, le tellurure de plomb, le tellurure de cadmium, le tellurure de zinc, le séléniure de cadmium, le séléniure de zinc, des verres ou des mélanges de ceux-ci.

2. Procédé selon la revendication 1,
caractérisé en ce que
la couche est appliquée entre deux feuilles envoyées en sens contraire sur des cylindres de vaporisation.

3. Procédé selon l'une quelconque des revendications 1 ou 2,
caractérisé en ce qu'
on applique en outre une couche métallique mince et transparente.

4. Procédé selon l'une quelconque des revendications 1 à 3,
caractérisé en ce que
les couches sont appliquées par vaporisation thermique.

5. Procédé selon l'une quelconque des revendications 1 à 4,
caractérisé en ce que
la couche barrière et d'assemblage est appliquée par pulvérisation cathodique.

6. Procédé selon l'une quelconque des revendications 1 à 5,
caractérisé en ce que
les feuilles sont choisies dans l'ensemble constitué par le polyester, le polypropylène, le polyéthylène, le polyamide, le polycarbonate, la cellulose régénérée, l'acétate de cellulose, le poly(acide hydroxybutyrique) et leurs copolymères, des matières plastiques à base d'amidon ou des matières plastiques avec addition d'amidon, des polycarbonates aliphatiques et des polyesters, des polypeptides, des polysaccharides, le papier, le carton ou d'autres matériaux biologiquement dégradables, ainsi que des associations de ceux-ci sous forme de stratifiés ou de mélanges ou sous forme revêtue.
